# EUROPEAN PATENT SPECIFICATION

(11) **EP 3 057 119 B1**
(45) Date of publication and mention of the grant of the patent: **02.08.2017**
(21) Application number: 16154784.9
(22) Date of filing: 09.02.2016
(51) Int. Cl.: H01J 37/32, H01J 37/34

(54) **COATING APPARATUS AND COATING PROCESS FOR NDFEB MAGNETS**
BESCHICHTUNGSVORRICHTUNG UND BESCHICHTUNGSVERFAHREN FÜR NDFEB-MAGNETEN
APPAREIL DE REVÊTEMENT ET PROCÉDÉ DE REVÊTEMENT POUR AIMANTS NDFEB

(30) Priority: 11.02.2015 CN 201510070271
(43) Date of publication of application: 17.08.2016
(73) Proprietor: Yantai Shougang Magnetic Materials Inc., 265500 Yantai (CN)
(72) Inventor: Yang, Kunkun, 265500 Yantai-City (CN); Peng, Zhongjie, 265500 Yantai-City (CN)
(74) Representative: Gulde & Partner

(56) References cited:
- CN-A- 102 969 110
- US-A- 4 966 668

## Description

The present invention relates to a processing technology of NdFeB magnets. To be specific, there is provided a coating apparatus and a coating process for NdFeB magnet.

### Technological Background

NdFeB magnets have been developed in 1983 as a new kind of magnetic functional material. The magnets include a Nd2Fe14B phase and show enriched neodymium in grain boundary. However, the material has a poor corrosion resistance and the magnetic properties are easily influenced by temperature. It is possible to form an anti-corrosion metal film on the surface of NdFeB magnet by vacuum coating, and said coating process is safety, clean, and ensures little damage to the magnet.

Currently multi-arc ion plating, magnetron sputtering deposition technology, magnetron multi arc ion plating are used to form anti-corrosion metal films and functional metal films on the surface of NdFeB magnets. However, there are restrictions due to the target material (target material should not be magnetic) and the low utilization limit of the method mentioned above. Hence, the processing costs are quite high.

One may form metal film layer on the surface of NdFeB magnet by vacuum evaporation, and the utilization will be higher than by multi-arc ion plating, magnetron sputtering deposition and magnetic control multi arc ion plating. However, it is difficult to form some metal film which have high melting points, and moreover, the high temperature during the coating process will change magnetic texture, furthermore the magnetic performance of NdFeB magnet will deteriorate. A sputter apparatus to treat and coat NdFeB magnets is disclosed in US4966668A whereas CN102969110A discloses treating NdFeB magnets by a glow discharge process.

### Summary of Invention

The invention aims to overcome the shortage of the present existing technologies above, and provides an improved coating apparatus for NdFeB magnets. The invention further provides a coating process for NdFeB magnets.

The invention also aims to overcome the shortage of the low target utilization and high temperature inside the apparatus during the coating process of the present existing technologies.

According to the present invention there is provided a coating apparatus for NdFeB magnets as defined in claim 1 and a corresponding coating process as defined in claim 4. The apparatus includes:
a vacuum chamber,
a source and a cathode being arranged within the vacuum chamber, the source and cathode being positioned with respect to each other in parallel and equidistant,
a thermal shield surrounding the source and the cathode,
an anode being arranged at a top of the vacuum chamber, wherein the anode and cathode are connected to a positive electrode and negative electrode of a pulsed bias power supply respectively, the anode and source are connected to the positive electrode and negative electrode of a DC bias power supply respectively, and the anode is grounded,
an argon gas entrance positioned at a bottom of the vacuum chamber,
a vacuum system being in communication with the vacuum chamber,
a furnace door positioned at a front side of vacuum chamber,
an observation window positioned at the center of the furnace door, and
an optical thermometer being placed outside of the vacuum chamber, the position of the optical thermometer corresponds to that of the observation window.

Preferably, a distance from the surface of source to that of the cathode varies between 5 to 200mm.

A structure of the source and the cathode may be plate type, vertical type or cylindrical type.

The coating process for NdFeB magnets includes the step of providing the mentioned coating apparatus. The process further includes the steps of:
a) Drying NdFeB magnet in drying oven after degreasing and pickling or sand blasting;
b) Taking a metallic target which will be used to form a film as the source, and the NdFeB magnet as the cathode; the distance from the surface of NdFeB magnet to that of metal target varies between 5-200 mm;
c) Pumping the vacuum chamber to 3 * 10⁻³ to 9 * 10⁻¹ Pa, then filling argon gas until the vacuum keeping at 10 to 100 Pa;
d) Turning on the cathode power and turning up the voltage gradually, cleaning the NdFeB magnet with the glow plasma which is produced during the process of adjusting voltage, then turning down the cathode voltage to zero when cleaning is done;
e) Turning on the source power and turning up the voltage gradually, cleaning the sources target with the glow plasma which is produced during the process of adjusting voltage, then turning down the cathode voltage to zero when cleaning is done;
f) Turning up the source voltage and cathode voltage, and keeping the voltage difference between the source electrode and the cathode at 0 to 500V, wherein the source voltage is higher than the cathode voltage; keeping the voltage of the source and the cathode stable when the temperature of NdFeB magnet reaches 400 to 1000°C then keeping the temperature for 1 to 100h; and
g) Turning off the power after finishing the temperature maintaining duration, cooling the NdFeB magnet to room temperature and then measuring the thickness of the film.

The coating apparatus and the coating process mentioned in the present invention have prominent features and show significant progress:
1. The thickness of the metal film formed on the NdFeB magnet is uniform and the metal targets have high material utilization.
2. The temperature is low during the entire coating process and, accordingly, damage of the magnet is lowered.
3. The process of coating has environment benefits since it produces less pollution waste, and is easily controlled.
4. The apparatus has a simple structure and less restrictions to the target.

### Brief Description of Figures

Figure 1 is a schematic illustration of an apparatus according to one embodiment of the present invention;
Figure 2 is a schematic illustration of a plate type arrangement of the source and the cathode;
Figure 3 is a schematic illustration of a vertical type arrangement of the source and the cathode.
Figure 4 is a schematic illustration of a cylindrical type arrangement of the source and the cathode.

### Detailed Description of the Invention

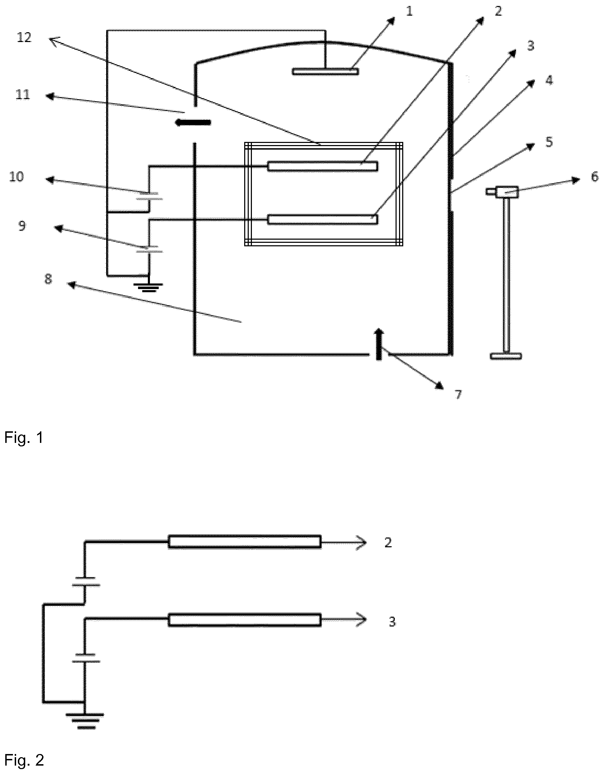

Embodiment 1 of the present invention is schematically illustrated in Figures 1 and 2. The structure of a source 2 and a cathode 3 is plate type; an anode 1 lays at the top of a vacuum chamber 8. The source 3 and the cathode 2 are parallel, equidistant and insulated in the vacuum chamber. A distance from the surface of source to that of cathode 3 varies between 5 to 200mm. A thermal shield 12 is arranged outside the source 2 and the cathode 3. The anode 1 and the cathode 3 is connected to a positive electrode and a negative electrode of a pulsed bias power supply 9 respectively. The anode 1 and source 2 are connected to the positive electrode and negative electrode of a DC bias power supply 10 respectively and the anode 1 is grounded. A vacuum systems 11 is arranged at a rear side of the vacuum chamber 8 and an argon gas entrance 7 (inlet) is positioned at the bottom of the vacuum chamber 8. A furnace door 4 is positioned at the front of the vacuum chamber 8. An observation window 5 is designed at the center of furnace door 4. An optical thermometer 6 is positioned outside of the vacuum chamber 8. The position of the optical thermometer 6 correspond to that of the observation window 5 and the temperature of the cathode 3 can be measured by the optical thermometer 6.

The metal, which will form an anti-corrosive film on the magnet, is selected as material of the source 2. The metal may be selected from dysprosium, terbium, holmium, praseodymium, neodymium, niobium cobalt, molybdenum, copper, titanium, aluminium, or its alloys. A NdFeB magnet will act as the cathode 3.

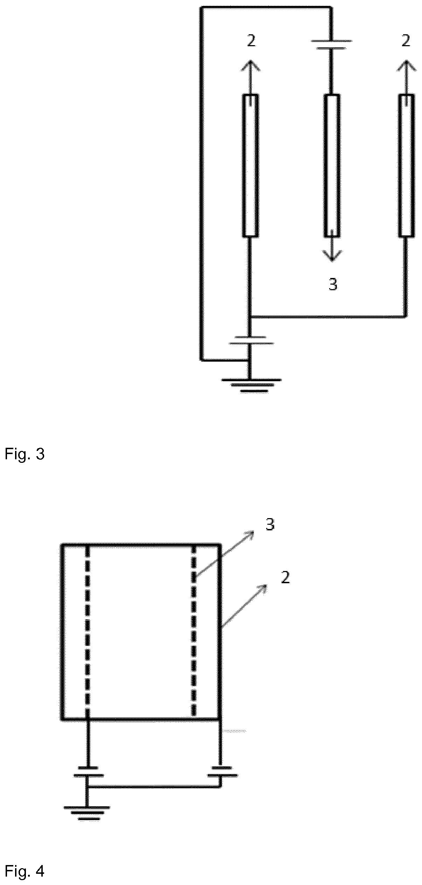

According to the embodiment illustrated in Figure 3, the arrangement/structure of the source 2 and the cathode 3 is of vertical type.

According to the embodiment illustrated in Figure 4, the arrangement/structure of the source 2 and the cathode 3 is of cylindrical type.

The basic principle of the special coating apparatus is double glow plasma surface metallurgy, and the coating process of the coating apparatus mentioned above is as follows:
1. Drying NdFeB magnet in drying oven after degreasing and pickling or sand blasting;
2. Taking the metallic target which will be used to form the film as the source, and the NdFeB magnet as the cathode; the distance from the surface of NdFeB magnet to that of metal target varies between 5-200 mm;
3. Pumping the vacuum chamber to 3 * 10⁻³∼9 * 10⁻¹ Pa, then filling argon gas until the vacuum keeping at 10∼100 Pa;
4. Turning on the cathode power and turning up the voltage gradually, cleaning the NdFeB magnet with the glow plasma which produced during the process of adjusting voltage, then turning down the cathode voltage to zero when cleaning is done;
5. Turning on the source power and turning up the voltage gradually, cleaning the sources target with the glow plasma which produced during the process of adjusting voltage, then turning down the cathode voltage to zero when cleaning is done;
6. Turning up the source voltage and cathode voltage, and keeping the voltage difference between the source electrode and the cathode at 0 to 500V (the source voltage is higher than the cathode voltage); keeping the voltage of the source and the cathode stable when the temperature of NdFeB magnet reaches 400 to 1000°C, then keeping the temperature for 1 to 100h;
7. Turning off the power after finishing the temperature maintaining duration, cooling the NdFeB magnet to room temperature and then measuring the thickness of the film.

### Listing of Reference Signs

- 1: anode
- 2: source
- 3: cathode
- 4: furnace door
- 5: observation window
- 6: optical thermometer
- 7: entrance of argon gas
- 8: vacuum chamber
- 9: pulsed bias power supply
- 10: DC bias power supply
- 11: vacuum system
- 12: thermal shield

## Claims

1. A coating apparatus for NdFeB magnets including:
a vacuum chamber (8),
a source (2) and a cathode (3) being arranged within the vacuum chamber (8), the source (2) and cathode (3) being positioned with respect to each other in parallel and equidistant,
a thermal shield (12) surrounding the source (2) and the cathode (3),
an anode (1) being arranged at a top of the vacuum chamber (8), wherein the anode (1) and cathode (3) are connected to a positive electrode and negative electrode of a pulsed bias power supply (9) respectively, the anode (1) and source (2) are connected to the positive electrode and negative electrode of a DC bias power supply (10) respectively, and the anode (1) is grounded,
an argon gas entrance (7) positioned at a bottom of the vacuum chamber (8),
a vacuum system (11) being in communication with the vacuum chamber (8),
a furnace door (4) positioned at a front side of vacuum chamber (8),
an observation window (5) positioned at the center of the furnace door (4), and
an optical thermometer (6) being placed outside of the vacuum chamber (8), the position of the optical thermometer (6) corresponds to that of the observation window (5).

2. The coating apparatus according to claim 1, wherein a distance from the surface of source (2) to that of the cathode (3) varies between 5 to 200mm.

3. The coating apparatus according to claim 1, wherein a structure of the source (2) and the cathode (3) is plate type, vertical type or cylindrical type.

4. A coating process for NdFeB magnets, the process including the step of providing a coating apparatus according to one of claim 1 through 3 and further including the steps of:
a) Drying NdFeB magnet in drying oven after degreasing and pickling or sand blasting;
b) Taking a metallic target which will be used to form a film as the source, and the NdFeB magnet as the cathode; the distance from the surface of NdFeB magnet to that of metal target varies between 5-200 mm;
c) Pumping the vacuum chamber to 3 * 10⁻³ to 9 * 10⁻¹ Pa, then filling argon gas until the vacuum keeping at 10 to 100 Pa;
d) Turning on the cathode power and turning up the voltage gradually, cleaning the NdFeB magnet with the glow plasma which is produced during the process of adjusting voltage, then turning down the cathode voltage to zero when cleaning is done;
e) Turning on the source power and turning up the voltage gradually, cleaning the sources target with the glow plasma which is produced during the process of adjusting voltage, then turning down the cathode voltage to zero when cleaning is done;
f) Turning up the source voltage and cathode voltage, and keeping the voltage difference between the source electrode and the cathode at 0 to 500V, wherein the source voltage is higher than the cathode voltage; keeping the voltage of the source and the cathode stable when the temperature of NdFeB magnet reaches 400 to 1000°C then keeping the temperature for 1 to 100h; and
g) Turning off the power after finishing the temperature maintaining duration, cooling the NdFeB magnet to room temperature and then measuring the thickness of the film.

## Patentansprüche

1. Beschichtungsvorrichtung für NdFeB-Magneten, Folgendes beinhaltend:
eine Unterdruckkammer (8),
eine Source-Elektrode (2) und eine Kathode (3), die in der Unterdruckkammer (8) angeordnet sind, wobei die Source-Elektrode (2) und die Kathode (3) im Verhältnis zueinander parallel und gleich beabstandet positioniert sind,
eine Wärmeabschirmung (12), welche die Source-Elektrode (2) und die Kathode (3) umgibt,
eine Anode (1), die an einer Oberseite der Unterdruckkammer (8) angeordnet ist, wobei die Anode (1) und die Kathode (3) mit einer positiven Elektrode beziehungsweise einer negativen Elektrode einer gepulsten Bias-Energieversorgung (9) verbunden sind, wobei die Anode (1) und die Source-Elektrode (2) mit der positiven beziehungsweise der negativen Elektrode einer Gleichstrom-Bias-Energieversorgung (10) verbunden sind und die Anode (1) geerdet ist,
einen Argongaseinlass (7), der an einer Unterseite der Unterdruckkammer (8) positioniert ist,
ein Unterdrucksystem (11), das in Verbindung mit der Unterdruckkammer (8) steht,
eine Ofentür (4), die an einer Vorderseite der Unterdruckkammer (8) positioniert ist,
ein Beobachtungsfenster (5), das in der Mitte der Ofentür (4) positioniert ist, und
ein optisches Thermometer (6), das außerhalb der Unterdruckkammer (8) platziert ist, wobei die Position des optischen Thermometers (6) der des Beobachtungsfensters (5) entspricht.

2. Beschichtungsvorrichtung nach Anspruch 1, wobei ein Abstand von der Oberfläche der Source-Elektrode (2) zu der der Kathode (3) zwischen 5 und 200 mm variiert.

3. Beschichtungsvorrichtung nach Anspruch 1, wobei eine Struktur der Source-Elektrode (2) und der Kathode (3) von der plattenförmigen Art, der vertikalen Art oder der zylinderförmigen Art sind.

4. Beschichtungsverfahren für NdFeB-Magneten, wobei das Verfahren den Schritt des Bereitstellens einer Beschichtungsvorrichtung nach einem der Ansprüche 1 bis 3 und ferner folgende Schritte beinhaltet:
a) Trocknen eines NdFeB-Magneten im Trocknungsofen nach dem Entfetten und Abbeizen oder Sandstrahlen,
b) Hernehmen eines metallischen Ziels, das dafür verwendet werden wird, einen Film als Source-Elektrode zu bilden, und des NdFeB-Magneten als Kathode, wobei der Abstand von der Oberfläche des NdFeB-Magneten zu der des Metallziels zwischen 5 und 200 mm variiert,
c) Auspumpen der Unterdruckkammer auf 3*10⁻³ bis 9*10⁻¹ Pa, dann Einfüllen von Argongas, bis der Unterdruck bei 10 bis 100 Pa gehalten wird,
d) Anschalten der Kathoden-Energie und schrittweises Hochregeln der Spannung, Reinigen des NdFeB-Magneten mit dem Glühplasma, das während des Verfahrens des Justierens der Spannung erzeugt wird, dann Herunterregeln der Kathodenspannung auf null, wenn das Reinigen erfolgt ist,
e) Anschalten der Source-Elektroden-Energie und schrittweises Hochregeln der Spannung, Reinigen des Source-Elektroden-Ziels mit dem Glühplasma, das während des Verfahrens des Justierens der Spannung erzeugt wird, dann Herunterregeln der Kathodenspannung auf null, wenn das Reinigen erfolgt ist,
f) Hochregeln der Source-Elektroden-Spannung und der Kathodenspannung und Halten der Spannungsdifferenz zwischen der Source-Elektrode und der Kathode bei 0 bis 500 V, wobei die Source-Elektroden-Spannung höher als die Kathodenspannung ist, Stabil-Halten der Spannung der Source-Elektrode und der Kathode, wenn die Temperatur des NdFeB-Magneten 400 bis 1000 °C erreicht hat, dann Halten der Temperatur über 1 bis 100 h und
g) Abschalten der Energie nach dem Beenden der Temperaturhaltezeit, Kühlen des NdFeB-Magneten auf Raumtemperatur und dann Messen der Dicke des Films.

## Revendications

1. Dispositif de revêtement pour aimants NfFeB incluant :
une chambre à vide (8),
une source (2) et une cathode (3) étant disposées à l'intérieur de la chambre à vide (8), la source (2) et la cathode (3) étant positionnées l'une par rapport à l'autre en parallèle et de manière équidistante,
un écran thermique (12) entourant la source (2) et la cathode (3),
une anode (1) étant disposée à un sommet de la chambre à vide (8), dans lequel l'anode (1) et ma cathode (3) sont connectés à une électrode positive et une électrode négative d'une alimentation électrique à polarisée pulsée (9) respectivement, l'anode (1) et la source (2) sont connectées à l'électrode positive et l'électrode négative d'une alimentation électrique à polarisation pulsée (10) respectivement, et l'anode (1) est mise à la terre ,
une entrée de gaz argon (7) positionnée à une base de la chambre à vide (8),
un système à vide (11) étant en communication avec la chambre à vide (8),
une porte de four (4) positionnée au niveau d'un côté avant de la chambre à vide (8),
une fenêtre d'observation (5) positionnée au centre de la porte de four (4), et
un thermomètre optique (6) étant placé à l'extérieur de la chambre à vide (8), la position du thermomètre optique (6) correspond à celle de la fenêtre d'observation (5).

2. Dispositif de revêtement selon la revendication 1, dans lequel la distance de la surface de la source (2) à celle de la cathode (3) varie entre 5 et 200 mm.

3. Dispositif de revêtement selon la revendication 1, dans lequel une structure de la source (2) et la cathode (3) est de type à plaque, de type vertical ou de type cylindrique.

4. Processus de revêtement pour aimants NdFeB, le processus incluant l'étape de fourniture d'un dispositif de revêtement selon une des revendications 1 à 3 et incluant en outre les étapes consistant à :
a) sécher l'aimant NdFeB dans un four de séchage après dégraissage et décapage ou sablage ;
b) prendre une cible métallique sui sera utilisée pour former un film comme la source, et l'aimant NdFeB comme la cathode ; la distance de la surface de l'aimant NdFeB à celle du métal varie entre 5-200 mm ;
c) pomper la chambre à vide à 3*10⁻³ à 9*10⁻¹ Pa, puis remplir le gaz argon jusqu'à ce que la gaz soit maintenu à 10 à 100 Pa ;
d) mettre sous tension l'alimentation électrique de cathode et augmenter graduellement la tension, en nettoyant l'aimant NdFeB avec le plasma à décharge luminescente qui est produit pendant le processus d'ajustement de tension, puis éteindre la tension de cathode à zéro lorsque le nettoyage est effectué ;
e) mettre sous tension l'alimentation électrique de source et augmenter graduellement la tension, en nettoyant la cible source avec le plasma à décharge luminescente qui est produit pendant le processus d'ajustement de tension, puis éteindre la la tension de cathode à zéro lorsque le nettoyage est effectué ;
f) augmenter la tension source et la tension de cathode, et maintenir la différence de tension entre l'électrode source et la cathode à 0 à 500 V, dans lequel la tension source est plus haute que la tension de cathode ; maintenir la tension de la source et la cathode stable lorsque la température de l'aimant NdFeB atteint 400 à 1000°C tout en maintenant la température à 1 à 100h ; et
g) mettre hors tension l'alimentation électrique après la fin de la durée de maintien de température, refroidir l'aimant NdFeB à la température de la pièce et ensuite mesurer l'épaisseur du film.
